# EUROPEAN PATENT APPLICATION

(11) **EP 2 017 367 A1**
(43) Date of publication of application: **21.01.2009**
(21) Application number: 07112691.6
(22) Date of filing: 18.07.2007
(51) Int. Cl.: C23C 14/20, C23C 14/35, C23C 14/56

(54) **Sputter coating device and method of depositing a layer on a substrate**

(71) Applicant: Applied Materials, Inc., Santa Clara, CA 95054 (US)
(72) Inventor: Scholhammer, Jim, Santa Clara, CA 95054 (US); Hoffmann, Uwe, 63755 Alzenau (DE); Dieguez-Campo, Jose Manuel, 63457 Hanau (DE)
(74) Representative: Lermer, Christoph

(57) **Abstract**

A sputter coating device (100) comprises a vacuum coating chamber, and substrates (110a and 110b) arranged within. Furthermore, the sputter coating device (100) comprises a cylindrical hollow cathode including a rotatable target (102) rotating around a central axis (A), and a magnet assembly (104) which is arranged within the hollow cathode and arranged such that confining plasma zones (106) are generated in an area (108) above the surface (102') of the target (102). The substrates have an OLED layer (111a and 111b), respectively, deposited on the substrate surface. An intermediate area (108) is arranged between the target surface (102') and a shield (109) which shields particles sputtered from the surface (102') of the target (102) that move in a direction towards the shield (109). On each side of the shield (109) passages (112a and 112b) (indicated by arrows) are provided between an intermediate area (108) (defined by the target surface (102') and the shield (109)) and the coating areas (113a,113b). Through these passages (112a and 112b) only sputtered particles which have been scattered in the intermediate area (108) may enter coating areas (113a,113b) via paths (112a and 112b), respectively, and impinge the OLED layers (111a or 111b).

## Description

### TECHNICAL FIELD

The present invention relates to a sputter coating device for depositing a layer on a substrate having an organic material layer deposited thereon. Furthermore, the invention relates to a method of depositing a layer on a substrate having an organic material layer deposited thereon.

### PRIOR ART

In many applications organic material layers such as organic electronics, OLEDs, etc. are part of a layer stack. Usually, organic material layers are functional layers that require a metallisation layer, a contact layer or a protective layer deposited directly or indirectly on the organic material layer.

A conventional process used for coating organic material layers, e.g. OLED layers, with a protective or metallization layer without damaging the organic material layer is an evaporation of coating particles on top of the organic material layer. In the evaporation process a metal source may be used. Furthermore, special process conditions may be provided like particular OLED layer stacks including protection layers.

Another approach is to use standard sputter processes like magnetron sputtering. However, it has been discovered that the underlying organic layer is considerably damaged when using conventional sputtering. Therefore, in order to provide a softer sputtering process, a face-to-face sputter concept has been introduced thereby reducing risk of damaging the organic layer. This may be due to a reduced velocity of the particles impinging the organic layer. This technology has, for example, been described in EP 1 505 170 B1.

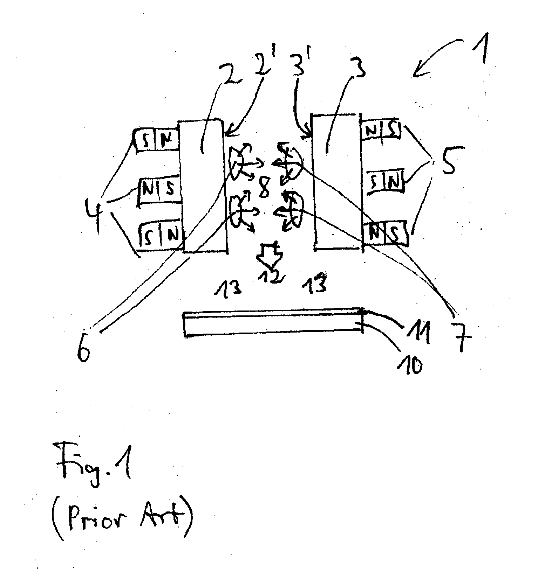

Figure 1 illustrates another conventional face-to-face sputtering apparatus 1 comprising a first target 2 and a second target 3. The first sputter surface 2' of the first target 2 and the second sputter surface 3' of the second target 3 are arranged such as to face each other.

The first target 2 comprises a first magnet assembly 4 to generate at least one plasma generation (or plasma confinement) zone 6 above the surface 2' of the first target 2. The second target 3 comprises a second magnet assembly 5 for generating at least a second plasma generation (or plasma confinement) zone 7 above the surface 3' of the second target 3. Within the plasma zones 5 and 7 ions are generated for sputtering coating particles or reaction particles from the target surfaces 2' and 3', respectively. The prevailing direction of the movement of the sputtered particles is directed at the opposite surface 3' and 2', respectively, of the opposing target 3 and 2, respectively.

However, a number of sputtered particles may be scattered in the intermediate zone 8 between the target surfaces 2' and 3', and enter a coating zone 13 via a path 12. The scattered particles have lost enough kinetic energy while being scattered such that they do not damage the organic layer 11 when impinging the substrate 10.

However, there are some disadvantages when using these processes. First, the coating yield is very low and thus the throughput of the substrates is unsatisfactory. Furthermore, particularly when coating with reactive particles such as A1, the use of conventional face-to-face sputter arrangements results in re-deposition of coating material from one magnetron to the other. In reactive processes like sputtering of Indium Tin Oxide (ITO), this could result in poisoning of the targets involved in the coating process. Even for non-reactive processes like sputtering of A1 this could result in the formation of a layer re-deposition area of the target where no sputtering occurs. This may cause shorts at the target or, if the particles reach the substrate, they may destroy the substrate.

### OBJECT OF THE INVENTION

It is an obj ect of the present invention to provide a device and a process for damage free or damaged reduced sputter coating on top of an organic material layer, e.g. on top of an OLED layer, the process having an acceptable coating rate.

### TECHNICAL SOLUTION

This object is solved by providing a sputter coating device according to claim 1 and a method of depositing a layer on a substrate according to claim 10.

A sputter coating device according to the invention for depositing a layer on a substrate having an organic material layer deposited thereon, comprises: a coating chamber; a substrate having an organic material layer deposited thereon; at least a rotatable cathode unit arranged in said coating chamber comprising at least one rotatable target and a magnet assembly for generating at least one plasma confinement zone arranged above at least a surface section of said target; a scattering zone for scattering sputtered particles, and means for selectively preventing a ratio of said sputtered particles from moving to the surface of said substrate.

Said means prevent a ratio of sputtered particles from moving from said surface section of said target to the surface of said substrate on a direct path, i.e. without being scattered. This direct path would usually be a substantially linear path. The scattering zone is located on the path of particles between the target surface and the substrate surface. The term scattering zone may be interpreted in a broad sense, including e. g. a deflection or reflection of particles resulting in a loss of kinetic energy and/ or a change of the direction of movement of the particles. Particles in the sense of the invention are particles sputtered from the target, i.e. atoms, ions, radicals, molecules, but not mote-like particles flaking off the target surface.

Said means acts as kind of a filter that filters particles from a stream of sputtered particles, especially the particles that have not been scattered in the scattering zone, thus allowing only scattered particles to impinge the substrate surface.

Particularly, said means comprises an arrangement and/or configuration of said surface section, said scattering zone, and said substrate surface such that at least a ratio of said sputtered particles scattered in said scattering zone passes said means to impinge said substrate surface.

In a preferred embodiment, said means comprises at least one passage between said scattering zone and said at least one substrate, wherein said passage is arranged and/or configured for allowing selective passage of particles scattered in said scattering zone to said at least one substrate.

The sputter coating device is particularly used for depositing a thin film, e.g. a protective film, a metallization and/or electrode layer, e.g. an A1 layer, a TCO (transparent conducting oxides) layer such as ITO (indium tin oxide), etc., on an organic material layer. An organic material layer is a layer that comprises at least an organic material, such as an organic electronics layer or an OLED (Organic Light Emitting Device) layer. The film may be deposited directly on the underlying organic material layer or indirectly, i.e. on top of one or more layers deposited on the organic material layer before depositing the thin film in accordance with the present invention. For example, in some applications, a thin layer of LiF or other materials is deposited on the organic material layer before the thin film according to the present invention is deposited. Due to the high reactivity of oxygen radicals, particularly the deposition of TCO layers entails major difficulties and problems like poisoning of the targets.

An important feature of the present invention is that at least one rotatable cathode unit is used. The power of the cathode may be DC, RF, mixtures of DC and RF, or pulse modulated power. A rotatable cathode comprises a cylindrical hollow target having a magnet assembly (magnetron), a cooling system, etc., arranged therein. The particular advantages of using rotatable cathodes in the arrangement according to the present invention are e. g. a reduction of poisoning of a second target that may be involved in the coating process, in the case of reactive processes. Furthermore, an advantageous design of shields may be provided. Because the shields may be exchanged easily, a simple maintenance of the coating device is facilitated. Moreover, rotatable targets have a high yield and good material utilization due to the uniform erosion of the target material.

In order to prevent damage caused by direct particles impinging the organic material layer or a thin layer deposited on the organic material layer the present invention uses an arrangement having rotatable cathodes with a magnet system facing away from the substrate surface. This results in coating conditions where only scattered particles impinge the substrate surface. Particles that are not scattered may be captured on a shield.

The deposition of the layer on top of the organic material layer (or a thin layer deposited thereon) may be provided in a static or in a dynamic process. In a static coating process the substrate is fixedly arranged within the vacuum coating chamber during the coating process. In a dynamic coating process the substrate is moved relative to the cathode while being coated.

The rotatable target rotates around an axis and moves relative to a fixed magnet assembly. The magnet assembly generates a plasma confinement zone. In magnetron plasma sputtering processes the coating and/or (in case of a reactive sputtering process) the reactive particles are essentially sputtered from a surface section of the target surface which is near or adjacent to the plasma confinement zone.

The target surface sections near the plasma confinement zones are arranged in one or more perimeter sections of the target surface. The perimeter sections of the target surface are not arranged opposite the substrate surface like in a conventional sputter process. Particularly, the magnet assembly may comprise magnet bars extending parallel to the rotational axis of the target. The magnet bars are not arranged near a connecting line between the rotational axis and the substrate surface, but facing away from the substrate surface. For example, they may be arranged in an angle of about 90° relative to the normal vector of the substrate area. This arrangement ensures that hardly any sputter particles reach the substrate surface on a direct path when moving away from the target surface without any collisions. Scattered particles, on the other hand, may reach the substrate surface. Due to the collision(s), the energy of the coating particles impinging the organic material layer (or a thin film deposited thereon) is reduced resulting in a reduction of the risk of damaging the organic material layer.

Particularly, the means for preventing sputtered particles from moving from said surface section of said target to the surface of said substrate to be coated directly on a substantially linear path comprises a configuration and/or an arrangement of said magnet assembly such that the average prevailing direction of movement of sputtered particles near the surface of the target is not directed towards the substrate surface.

According to the present invention, a direct movement of sputtered particles towards and onto the organic material layer is not desirable due to the ability of these particles having a high impulse to damage the organic material layer. Even if the organic material layer is provided with a thin film on top thereof, the organic material layer is not protected sufficiently from directly sputtered particles. Therefore, the magnet assembly is arranged in a direction that does not face the substrate surface, but rather is turned away (e.g. in an angle of 90°) from the substrate surface. Thus, the prevailing average direction of movement of particles sputtered from the target surface (before they may be scattered) is directed away from the substrate surface. There is no direct movement on a liner path, i.e. no movement free of collisions between the target surface section and the substrate surface. Only scattered particles which have lost much kinetic energy due to collisions with other particles impinge the organic layer without causing damage to the organic layer. In this way a damage free or damage reduced sputtering process on organic material layers, e.g. OLED layers, using rotatable cathode technology is provided.

Even if there was a statistical possibility that also directly sputtered particles may reach the surface, this is within the scope of the present invention as long as the number of these particles has been reduced compared to the number of scattered particles impinging the organic material layer.

In a preferred embodiment said means is configured such that there is a connecting path between said surface section of said target and said substrate surface to be coated for particles sputtered from said target surface and scattered in an area above the target surface. In other words there is a path providing an indirect connection between the sputter surface and the substrate surface such that only scattered particles may reach the substrate surface.

Said means may particularly comprise at least one shield for preventing particles sputtered from said target to impinge said substrate surface directly on a linear path.

It should be ensured that at least the majority of particles reaching the substrate surface were scattered during their travel from the target surface section to the substrate surface. Additional shields having openings may be particularly designed to optimize the number of scattered particles reaching the substrate surface and thus increasing the coating rate/yield. On the other hand, the number of particles impinging the substrate surface without being scattered on their way from the target surface to the substrate surface must be reduced.

Said sputter coating device may comprise at least a first rotatable cathode unit arranged in said coating chamber comprising at least a first rotatable target and a first magnet assembly for generating at least a first plasma confinement zone arranged above at least a first surface section of said first target, and at least a second cathode unit arranged in said coating chamber comprising at least a second target and a second magnet assembly for generating at least a second plasma confinement zone arranged above at least a second surface section of said second target, wherein said means are configured to prevent sputtered particles from moving from said first target surface and said second target surface to the surface of said substrate on a substantially linear path. The second cathode unit may be a flat or a rotatable cathode unit having a flat and rotatable target, respectively.

The power of the cathodes can be DC, RF, mixtures of DC and RF, or pulse modulated power. The two rotatables may also be used in a twin-mag mode. It is preferred that the main direction of the deposition is towards the other rotatable.

In a preferred embodiment said means comprises a configuration and/or arrangement of said first magnet assembly and said second magnet assembly such that said first surface section of said first target surface, and said second surface section of said second target surface are arranged face-to-face defining an intermediate zone there between.

The coating device of this embodiment comprises an arrangement of two targets with a magnet assembly attributed to each of the targets. The targets are particularly arranged in a face-to-face arrangement defining an intermediate zone between the targets. In this intermediate zone quite a high density of particles can be generated, thus increasing the probability of scattering of the particles and the rate of coating of the substrate with scattered particles. Furthermore, poisoning may be reduced in reactive processes, e.g. when coating with TCO, as rotatable targets are less susceptible for poisoning. In addition, at rotatable targets the re-deposition zone is reduced to a minimum (at both ends of the target) because each portion of the target surface passes the sputtering area as the target rotates.

Said sputter coating device may comprise at least one shield between said intermediate zone and said substrate surface, said shield having at least one opening for scattered particles to move towards said substrate surface.

The obj ect of the invention is also solved by providing a method of depositing a layer on a substrate having an organic material layer deposited thereon, said method comprising the steps of:
a) Providing a coating chamber;
b) Providing a substrate to be coated in said coating chamber having at least an organic material layer deposited thereon;
c) Providing at least one rotatable cathode unit arranged in said coating chamber comprising at least a rotatable target and a magnet assembly for generating at least one plasma confinement zone arranged above at least a surface section of said target;
d) Providing means for preventing sputtered particles from moving from said target surface to the substrate surface on a substantially direct path; and
e) Sputtering particles from said rotatable target.

Step d) may include providing a scattering zone for sputtered particles. When being scattered the particles lose kinetic energy and/ or change their direction of movement. Due to the different direction of movement of scattered and non-scattered particles, the non-scattered particles may be filtered from the stream of all particles reaching the scattering zone. The particles moving without having been scattered may be deposited on a shield. A ratio of the scattered particles moves in a direction to the substrate surface.

Particularly, step c) includes arranging said magnet assembly such that the average prevailing direction of movement of sputtered particles near the surface of the target is not directed towards said substrate surface.

In a preferred embodiment, step d) includes providing a connecting path between the surface section of the target and the substrate surface to be coated for particles sputtered from said target surface and scattered in said scattering zone.

Step d) may include providing at least one shield between said scattering zone and said substrate surface.

Particularly, step c) includes providing a first rotatable cathode unit arranged in said coating chamber comprising at least a first rotatable target and a first magnet assembly for generating at least a first plasma confinement zone arranged above at least a first surface section of said target, and at least a second cathode unit arranged in said coating chamber comprising at least a second target and a second magnet assembly for generating at least a second plasma confinement zone arranged above at least a second surface section of said second target. The second target may be a flat target or a rotatable target.

Step c) may include arranging said first magnet assembly and said second magnet assembly such that particles sputtered from said first target surface and said second target surface have a prevailing direction of movement towards the second target surface and the first target surface, respectively. This arrangement corresponds to a face-to-face arrangement of the magnet assemblies.

Particularly, step d) includes providing at least a shield having an opening for allowing scattered particles sputtered from said at least one target to pass through said opening and to impinge said substrate surface to be coated.

During step d) the substrate surface may be arranged substantially parallel relative to an average prevailing direction of movement of said sputtered particles near said target surface.

In a preferred embodiment, said method may further include the following steps: after depositing said layer on said organic material layer deposited on said substrate
f) sputtering particles from a rotatable target such that said sputtered particles have an average prevailing direction of movement towards said substrate surface to be coated for allowing said particles to impinge said substrate surface directly on a linear path.

In this embodiment, according to the basic method described above, a first thin layer, i.e. a sublayer, is deposited on the organic material layer. During step f) which refers to the formation of a thick second layer on the sublayer by direct sputtering, the sublayer protects the organic material layer from the influence of impinging sputtered particles having a high kinetic energy. The second layer may be coated in one or more additional cathodes which may be planar or rotatable cathodes.

The second layer may be of the same or similar material as the first layer, e.g. a metal material such as A1.

Particularly, step f) includes changing, after a first layer has been deposited on said substrate surface, the alignment of said magnet assembly from a direction not facing said substrate surface to a direction facing said substrate surface, and depositing a second layer on said first layer. In other words, the sputter direction is changed, for example by rotating the magnet system relative to the substrate in a direction towards the substrate. The second layer may be coated with the same rotatable cathode as the first layer by moving the magnet bar of the magnetron towards the substrate and therefore the main deposition direction directed towards the substrate. Of course, there is also the possibility to move the substrate from a position where the substrate surface does not face the magnet assembly to a position, where the substrate surface faces the magnet assembly.

Step f) may include transporting said substrate from a first rotatable target to a second rotatable target, and then sputtering particles from said second rotatable target to deposit a second layer on the first layer.

Said first layer deposited during step e) may have a thickness between 5 nm and 100 nm, and/or said second layer deposited in step f) may have a thickness between 10 nm and 1000 nm.

### BRIEF DESCRIPTION OF THE DRAWINGS

Further objects and advantages result from the following description of specific embodiments relating to the figures. The figures show:
- Figure 1: a conventional face-to-face target sputtering apparatus;
- Figure 2: a first embodiment of the present invention;
- Figure 3: a second embodiment of the present invention; and
- Figure 4: a method of depositing a layer on a substrate according to the present invention.

### DESCRIPTION OF SPECIFIC EMBODIMENTS

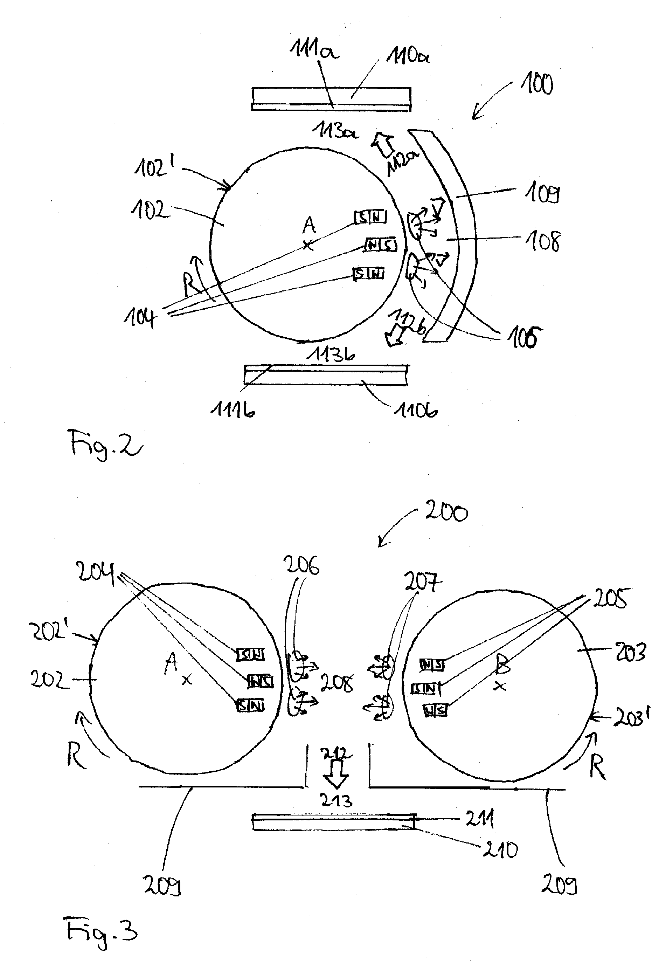

Figure 2 illustrates a first embodiment of a sputter coating device according to the present invention.

The sputter coating device 100 comprises a vacuum coating chamber (not illustrated), and substrates 110a and 110b arranged within the coating chamber. Furthermore, the sputter coating device 100 comprises a cylindrical hollow cathode including a rotatable target 102 rotating around a central axis A, and a magnet assembly 104 which is arranged within the hollow cathode and arranged such that confining plasma zones 106 are generated in an area 108 above the surface 102' of the target 102. The area 108 is arranged such that the prevailing direction of movement of particles sputtered from the surface 102' of the target 102 is not directed towards the substrate surface to be coated.

In this embodiment, there are two substrates 110a and 110b to be coated at the same time. Both substrates have an OLED layer 111a and 111b, respectively, deposited on the substrate surface. However, of course it is also possible to have only one substrate located near the particle source 108 in order to be coated. The coating may be provided on the organic layer 111a, 111b or on a thin film deposited thereon, e.g. a LiF film.

The area 108 is arranged between the target surface 102' and a shield 109 which shields particles sputtered from the surface 102' of the target 102 that move in a direction towards the shield 109. On each side of the shield 109 passages 112a and 112b (indicated by arrows) are provided between an intermediate area 108 (defined by the target surface 102' and the shield 109) and the coating areas 113a, 113b. Through these passages 112a and 112b only sputtered coating particles which have been scattered in the intermediate area 108 may enter coating areas 113a, 113b, respectively, and impinge the OLED layers 111a or 111b or thin films deposited thereon. Of course, it can not be prevented that also sputter gases like Argon, Oxygen (when sputtering TCOs), etc. pass the passages 112a and 112b. However, it is intended to reduce the number of particles sputtered from the target to impinge the substrate surface without having been scattered in the scattering zone 108.

In a static coating process the substrates 110a and 110b are immovable during the coating process, in a dynamic coating process the substrates 110a and 110b may be moved relative to the sputter coating device 100 in the coating chamber. When passing the sputter coating device, electrode layers are formed on top of said OLED layers 111a and 111b deposited on said substrates 110a and 110b, respectively.

Furthermore, a shield 109 is provided which shields particles sputtered from the surface 102' of the target 102 that move in a direction towards the shield 109. On each side of the shield 109 passages 112a and 112b (indicated by arrows) are provided between an intermediate area 108 (defined by the target surface 102' and the shield 109) and the coating areas 113a, 113b.

Through these passages 112a and 112b only sputtered particles which have been scattered in the intermediate area 108 may enter coating areas 113a, 113b via paths 112a and 112b, respectively, and impinge the OLED layers 111a or 111b.

Figure 3 is an illustration of a second embodiment of the inventive sputter coating device 200.

The sputter coating device 200 comprises a first rotatable cathode having a first target 202, and a second rotatable cathode having a second target 203. The targets 202 and 203 are rotatable around central axes A and B, respectively. Furthermore, the cathodes each comprise a magnet assembly 204 and 205, respectively. The magnets 204 and 205 are arranged such that two plasma confinement zone 206 and 207 are generated in a defined area between the targets 202 and 203.

The plasma confinement zones 206 and 207 are positioned in an intermediate space 208 between the targets 202 and 203. The particles sputtered from the target surfaces 202' and 203' in an area near the plasma confinement zones 206 and 207 have a prevailing direction of movement towards the other rotatable cathode 203 and 202, respectively. The magnet assemblies 204, 205 are arranged face-to-face.

Furthermore, the sputter coating device 200 may comprise a shield 209 having an opening 212 between the intermediate area 208 where a certain fraction of sputtered particles are scattered and enter a coating area 213 via the opening 212. Because the scattered particles have lost kinetic energy during the collision(s) with other particles, they have a relatively low kinetic energy when impinging the OLED layer 211 on the substrate 210. However, in some applications there may be no shield 209 required if the number of non-scattered particles impinging the substrate surface can be sufficiently reduced without a shield.

The advantage of the described embodiments is that the majority of particles has been scattered when entering the coating areas 213, 113a or 113b. Consequently, a very soft way of coating is provided when using the coating devices 100, 200 according to the invention. Thus the coating process does not cause damage to the organic layer.

By using one or more rotatable cathodes a uniform erosion of material from the target surfaces 202', 203', 102' may be obtained. For example, when using flat targets certain areas of the target surface are not sputtered. In a face-to-face arrangement particles from the other cathode may be deposited in these areas causing spurious effects.

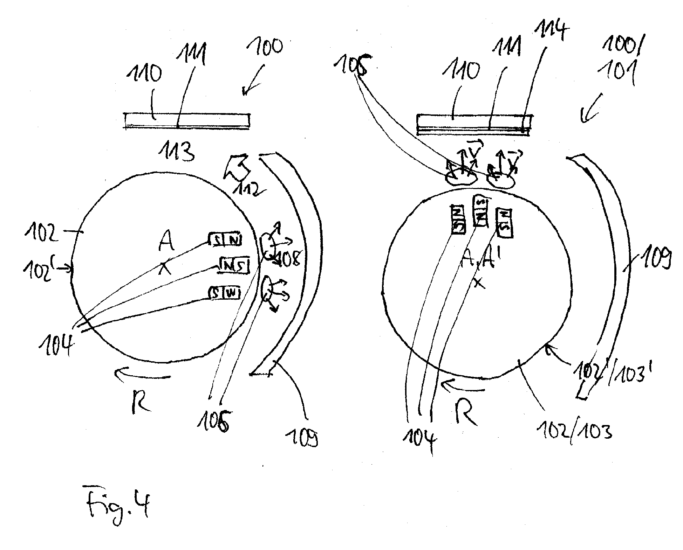

Figure 4 illustrates an operation mode of a sputter coating device according to the invention.

On the left side, corresponding to a first process, there is shown a sputter coating device 100 as shown in Figure 1.

In a first coating process a substrate 110 having an OLED layer 111 deposited thereon is coated with a first sublayer, e.g. a metal layer 114. During the sputter coating process the rotatable target 102 rotates around a central axis A. The sputter coating device 100 comprises a magnet assembly 104 which is arranged in the interior of the cylindrical hollow cathode 102 on a side not facing the surface of the substrate 110. Only particles scattered in the intermediate zone 108 may enter the coating area 113 and impinge the OLED layer 113. These particles form a thin electrode layer 114 on the organic layer 111, e.g. a thin metal layer 114 having a thickness d between 5 nm and 100 nm. The remaining particles (not scattered or scattered in another direction) are stopped by a shield 109.

In a second coating process (illustrated on the right side of Figure 4) which may be performed in the same sputter coating device 100 or in a different sputter coating device 101, a second thick layer is deposited on the first thin metal layer 114 formed in the described first step on top of the organic layer 111.

The second thick layer may be formed with the magnet assembly 104 of the rotatable cathode directed towards the surface of the substrate 110 and the first metal layer 114. In this configuration, the majority of particles sputtered from the target surface 102' near the plasma confinement zones 106 move directly to the substrate surface and impinge said thin layer 114 with a relatively high kinetic energy. However, they do not impinge the organic layer which is covered and protected by the thin layer 114. Therefore, the particles forming the second thick layer do not damage the OLED layer.

The second thick layer having a thickness d between 10 nm and 1000 nm may thus be produced with a much higher deposition rate. Only the thin layer must be deposited with a low rate in the first step. The thin metal layer and the thick layer deposited thereon may consist of the same or a similar material.

The second process may be performed after transporting the substrate 110 coated with an organic layer 111, an OLED layer 111, and a thin electrode layer 114 to a second sputter coating device 101 in order to deposit the second thick electrode layer.

Alternatively, the same sputter coating device 100 may be used for performing the second coating process with the magnet assembly 104 turned by 90 ° in a direction directly facing the surface to be coated. In this embodiment the same cathode may be used for both processes.

## Claims

1. A sputter coating device (100, 101, 200) for depositing a layer on a substrate (110, 110a, 110b, 210) having an organic material layer (111, 111a, 111b, 211) deposited thereon, said sputter coating device (100, 101, 200) comprising:
a coating chamber;
at least one substrate (110, 110a, 110b, 210) having a surface and an organic material layer (111, 111a, 111b, 211) deposited thereon;
at least a rotatable cathode unit arranged in said coating chamber comprising at least a rotatable target (102, 103, 202, 203) for sputtering particles from said target (102, 103, 202, 203) and a magnet assembly (104, 204, 205) for generating at least one plasma confinement zone (106, 206, 207) arranged above at least one surface section of said target (102, 103, 202, 203);
a scattering zone (108, 208) provided between said at least one surface section and
said substrate surface for scattering sputtered particles; and
means for selectively preventing a ratio of said sputtered particles from moving to the surface of said substrate.

2. The sputter coating device (100, 101, 200) according to claim 1,
**characterized in that**
said means comprises an arrangement and/or configuration of said surface section, said scattering zone (108, 208) and said substrate surface such that at least a ratio of said sputtered particles scattered in said scattering zone (108, 208) passes said means to impinge said substrate surface.

3. The sputter coating device (100, 101, 200) according to claim 1 or 2,
**characterized in that**
said means comprises at least one passage (112, 112a, 112b, 212) between said scattering zone (108, 208) and said at least one substrate (110, 110a, 110b, 210), wherein said passage (112, 112a, 112b, 212) is arranged and/or configured for a selective passage of particles scattered in said scattering zone (108, 208) to said at least one substrate surface.

4. The sputter coating device (100, 101, 200) according to any of the previous claims,
**characterized in that**
said means comprises a configuration and/or an arrangement of said magnet assembly (104, 204, 205) such that the average prevailing direction of movement of sputtered particles near the surface of the target (102, 103, 202, 203) is not directed towards said substrate surface.

5. The sputter coating device (100, 101, 200) according to any of the previous claims,
**characterized in that**
said means is configured such that there is a connecting path (112, 112a, 112b, 212) between said surface section of said target (102, 103, 202, 203) and said substrate surface to be coated for particles sputtered from said target surface and scattered in a defined area (108, 208).

6. The sputter coating device (100, 101, 200) according to any of the previous claims,
**characterized in that**
said means comprises at least one shield (109, 209).

7. The sputter coating device (200) according to any of the previous claims,
**characterized in that**
said sputter coating device (200) comprises at least a first rotatable cathode unit arranged in said coating chamber comprising at least a first rotatable target (202) and a first magnet assembly (204) for generating at least a first plasma confinement zone (206) arranged above at least a first surface section of said first target (202), and at least a second cathode unit arranged in said coating chamber comprising at least a second target (203) and a second magnet assembly (205) for generating at least a second plasma confinement zone (207) arranged above at least a surface section of said second target (203), wherein said means are configured to selectively prevent a ratio of said sputtered particles from moving to the surface of said substrate.

8. The sputter coating device (200) according to claim 7,
**characterized in that**
said means comprises a configuration and/or arrangement of said first magnet assembly (204) and said second magnet assembly (205) such that said first surface section of said first target surface, and said second surface section of said second target surface are arranged face-to-face defining an intermediate zone (208) there between.

9. The sputter coating device (200) according to claim 8,
**characterized in that** said sputter coating device (200) comprises at least one shield (209) between said intermediate zone (208) and said substrate surface, said shield (209) having at least one opening (212) for scattered particles to move towards said substrate surface.

10. A method of depositing a layer on a substrate (110, 110a, 110b, 210) having an organic material layer (111, 111a, 111b, 211) deposited thereon, said method comprising the steps of:
a. Providing a coating chamber;
b. Providing a substrate to be coated in said coating chamber having at least an organic material layer deposited thereon;
c. Providing at least one rotatable cathode unit arranged in said coating chamber comprising at least a rotatable target and a magnet assembly (104, 204, 205) for generating at least one plasma confinement zone arranged above at least a surface section of said target (102, 103, 202, 203);
d. Providing means for preventing sputtered particles from moving from said target surface to the substrate surface on a substantially direct path;
e. Sputtering particles from said rotatable target (102, 103, 202, 203) to form a layer (114) on said substrate.

11. The method according to claim 10,
**characterized in that** step c) includes arranging said magnet assembly (104, 204, 205) such that the average prevailing direction of movement of sputtered particles near the surface of the target (102, 103, 202, 203) is not directed towards said substrate surface.

12. The method according to claim 10 or 11,
**characterized in that**
step d) includes providing a connecting path (112, 112a, 112b, 212) between the surface section of the target (102, 103, 202, 203) and the substrate surface to be coated for particles sputtered from said target surface and scattered in a scattering zone (108, 208).

13. The method according to any of the previous claims 10 to 12,
**characterized in that**
step d) includes providing at least one shield (109, 209) between said scattering zone (108, 208) and said substrate surface.

14. The method according to any of the previous claims 10 to 13,
**characterized in that**
said step c) includes providing a first rotatable cathode unit arranged in said coating chamber comprising at least a first rotatable target (202) and a first magnet assembly (204) for generating at least one plasma confinement zone (206) arranged above at least a surface section of said target (202), and at least a second cathode unit arranged in said coating chamber comprising at least a second rotatable target (203) and a second magnet assembly (205) for generating at least a second plasma confinement zone (207) arranged above at least a surface section of said second target (203).

15. The method according to claim 14,
**characterized in that**
step c) includes arranging said first magnet assembly (204) and said second magnet assembly (205) such that particles sputtered from said first target surface and said second target surface have a prevailing direction of movement towards the second target surface and the first target surface, respectively.

16. The method according to any of the previous claims,
**characterized in that**
step d) includes providing at least a shield (109, 209) having an opening (112, 112a, 112b, 212) for allowing scattered particles sputtered from said at least one target to pass through said opening (112, 112a, 112b, 212) and to impinge said substrate surface to be coated.

17. The method according to any of the previous claims 10 to 16,
**characterized in that**
during said step e) the substrate surface is substantially arranged parallel relative to an average prevailing direction of movement of said sputtered particles near said target surface.

18. The method according to any of the previous claims 10 to 17,
**characterized in that**
said method further includes the following step:
after depositing said layer (114) on said substrate (110, 110a, 110b, 210) f) sputtering particles from a rotatable target (102, 103) such that said sputtered particles have an average prevailing direction of movement towards said substrate surface to be coated for allowing said particles to impinge said substrate surface directly.

19. The method according to claim 18,
**characterized in that**
step f) includes changing, after a first layer (114) has been deposited on said substrate surface, the alignment of said magnet assembly (104) from a direction not facing said substrate surface to a direction facing said substrate surface, and depositing a second layer on said first layer (114).

20. The method according to claim 18,
**characterized in that**
step f) includes transporting said substrate from a first rotatable target (102) to a second rotatable target (103), and sputtering particles from said second rotatable target (103).

21. The method according to any of the previous claims 18 to 20,
**characterized in that**
said first layer deposited during step e) has a thickness between 5 nm and 100 nm, and/or said second layer deposited in step f) has a thickness between 10 nm and 1000 nm.

## Amended claims

### Amended claims in accordance with Rule 137(2) EPC.

**1.** A sputter coating device (100, 101, 200) for depositing a layer on a substrate (110, 110a, 110b, 210) having an organic material layer (111, 111a, 111b, 211) deposited thereon, said sputter coating device (100, 101, 200) comprising:
a coating chamber;
at least one substrate (110, 110a, 110b, 210) having a surface and an organic material layer (111, 111a, 111 b, 211) deposited thereon;
at least a rotatable cathode unit arranged in said coating chamber comprising at least a rotatable target (102, 103, 202, 203) for sputtering particles from said target (102, 103, 202, 203) and a magnet assembly (104, 204, 205) for generating at least one plasma confinement zone (106, 206, 207) arranged above at least one surface section of said target (102, 103, 202, 203); and
means for selectively preventing a ratio of said sputtered particles from moving to the surface of said substrate,
**characterized in that**
said sputter coating device (100, 101, 200) comprises a scattering zone (108, 208) provided between said at least one surface section of said target and said surface of said substrate for scattering sputtered particles; wherein
said means for selectively preventing a ratio of said sputtered particles from moving to the surface of said substrate is configured for providing a selective passage of particles scattered in said scattering zone (108, 208) to said at least one surface of said substrate.

**2.** The sputter coating device (100, 101, 200) according to claim 1,
**characterized in that**
said means comprises an arrangement and/or configuration of said surface section, said scattering zone (108, 208) and said substrate surface such that at least a ratio of said sputtered particles scattered in said scattering zone (108, 208) passes said means to impinge said substrate surface.

**3.** The sputter coating device (100, 101, 200) according to claim 1 or 2,
**characterized in that**
said means comprises at least one passage (112, 112a, 112b, 212) between said scattering zone (108, 208) and said at least one substrate (110, 110a, 110b, 210), wherein said passage (112, 112a, 112b, 212) is arranged and/or configured for a selective passage of particles scattered in said scattering zone (108, 208) to said at least one substrate surface.

**4.** The sputter coating device (100, 101, 200) according to any of the previous claims,
**characterized in that**
said means comprises a configuration and/or an arrangement of said magnet assembly (104, 204, 205) such that the average prevailing direction of movement of sputtered particles near the surface of the target (102, 103, 202, 203) is not directed towards said substrate surface.

**5.** The sputter coating device (100, 101, 200) according to any of the previous claims,
**characterized in that**
said means is configured such that there is a connecting path (112, 112a, 112b, 212) between said surface section of said target (102, 103, 202, 203) and said substrate surface to be coated for particles sputtered from said target surface and scattered in a defined area (108, 208).

**6.** The sputter coating device (100, 101, 200) according to any of the previous claims,
**characterized in that**
said means comprises at least one shield (109, 209).

**7.** The sputter coating device (200) according to any of the previous claims,
**characterized in that**
said sputter coating device (200) comprises at least a first rotatable cathode unit arranged in said coating chamber comprising at least a first rotatable target (202) and a first magnet assembly (204) for generating at least a first plasma confinement zone (206) arranged above at least a first surface section of said first target (202), and
at least a second cathode unit arranged in said coating chamber comprising at least a second target (203) and a second magnet assembly (205) for generating at least a second plasma confinement zone (207) arranged above at least a surface section of said second target (203), wherein said means are configured to selectively prevent a ratio of said sputtered particles from moving to the surface of said substrate.

**8.** The sputter coating device (200) according to claim 7,
**characterized in that**
said means comprises a configuration and/or arrangement of said first magnet assembly (204) and said second magnet assembly (205) such that said first surface section of said first target surface, and said second surface section of said second target surface are arranged face-to-face defining an intermediate zone (208) there between.

**9.** The sputter coating device (200) according to claim 8,
**characterized in that**
said sputter coating device (200) comprises at least one shield (209) between said intermediate zone (208) and said substrate surface, said shield (209) having at least one opening (212) for scattered particles to move towards said substrate surface.

**10.** A method of depositing a layer on a substrate (110, 110a, 110b, 210) having an organic material layer (111, 111a, 111b, 211) deposited thereon, said method comprising the steps of:
a. Providing a coating chamber;
b. Providing a substrate to be coated in said coating chamber having at least an organic material layer deposited thereon; and
c. Providing at least one rotatable cathode unit arranged in said coating chamber comprising at least a rotatable target and a magnet assembly (104, 204, 205) for generating at least one plasma confinement zone arranged above at least a surface section of said target (102, 103, 202, 203);
**characterized by**
d. Providing means for preventing a ratio of sputtered particles from moving from said target surface to the surface of said substrate, said means being configured for providing a selective passage of particles scattered in said scattering zone (108, 208) to said surface of said substrate; and
e. Sputtering particles from said rotatable target (102, 103, 202, 203) to form a layer (114) on said substrate.

**11.** The method according to claim 10,
**characterized in that**
step c) includes arranging said magnet assembly (104, 204, 205) such that the average prevailing direction of movement of sputtered particles near the surface of the target (102, 103, 202, 203) is not directed towards said substrate surface.

**12.** The method according to claim 10 or 11,
**characterized in that**
step d) includes providing a connecting path (112, 112a, 112b, 212) between the surface section of the target (102, 103, 202, 203) and the substrate surface to be coated for particles sputtered from said target surface and scattered in a scattering zone (108, 208).

**13.** The method according to any of the previous claims 10 to 12,
**characterized in that**
step d) includes providing at least one shield (109, 209) between said scattering zone (108, 208) and said substrate surface.

**14.** The method according to any of the previous claims 10 to 13,
**characterized in that**
said step c) includes providing a first rotatable cathode unit arranged in said coating chamber comprising at least a first rotatable target (202) and a first magnet assembly (204) for generating at least one plasma confinement zone (206) arranged above at least a surface section of said target (202), and
at least a second cathode unit arranged in said coating chamber comprising at least a second rotatable target (203) and a second magnet assembly (205) for generating at least a second plasma confinement zone (207) arranged above at least a surface section of said second target (203).

**15.** The method according to claim 14,
**characterized in that**
step c) includes arranging said first magnet assembly (204) and said second magnet assembly (205) such that particles sputtered from said first target surface and said second target surface have a prevailing direction of movement towards the second target surface and the first target surface, respectively.

**16.** The method according to any of the previous claims,
**characterized in that**
step d) includes providing at least a shield (109, 209) having an opening (112, 112a, 112b, 212) for allowing scattered particles sputtered from said at least one target to pass through said opening (112, 112a, 112b, 212) and to impinge said substrate surface to be coated.

**17.** The method according to any of the previous claims 10 to 16,
**characterized in that**
during said step e) the substrate surface is substantially arranged parallel relative to an average prevailing direction of movement of said sputtered particles near said target surface.

**18.** The method according to any of the previous claims 10 to 17,
**characterized in that**
said method further includes the following step:
after depositing said layer (114) on said substrate (110, 110a, 110b, 210) f) sputtering particles from a rotatable target (102, 103) such that said sputtered particles have an average prevailing direction of movement towards said substrate surface to be coated for allowing said particles to impinge said substrate surface directly.

**19.** The method according to claim 18,
**characterized in that**
step includes changing, after a first layer (114) has been deposited on said substrate surface, the alignment of said magnet assembly (104) from a direction not facing said substrate surface to a direction facing said substrate surface, and depositing a second layer on said first layer (114).

**20.** The method according to claim 18,
**characterized in that**
step f) includes transporting said substrate from a first rotatable target (102) to a second rotatable target (103), and sputtering particles from said second rotatable target (103).

**21.** The method according to any of the previous claims 18 to 20,
**characterized in that**
said first layer deposited during step e) has a thickness between 5 nm and 100 nm, attd/ot said second layer deposited in step f) has a thickness between 10 nm and 1000 nm.
